# EUROPEAN PATENT SPECIFICATION

(11) **EP 3 248 035 B1**
(45) Date of publication and mention of the grant of the patent: **02.01.2019**
(21) Application number: 16702217.7
(22) Date of filing: 04.01.2016
(51) Int. Cl.: G02B 7/00, G02C 11/08, G02C 11/00, G02B 27/01

(54) **WEARABLE DISPLAY WITH BONDED GRAPHITE HEATPIPE**
AM KÖRPER TRAGBARE ANZEIGE MIT GEBUNDENEM GRAPHIT-WÄRMEROHR
AFFICHAGE À PORTER SUR SOI POURVU D'UN TUYAU DE CHAUFFAGE EN GRAPHITE LIÉ

(30) Priority: 20.01.2015 US 201514600753
(43) Date of publication of application: 29.11.2017
(73) Proprietor: Microsoft Technology Licensing, LLC, Redmond, Washington 98052-6399 (US)
(72) Inventor: NIKKHOO, Michael, Redmond, Washington 98052-6399 (US)
(74) Representative: CMS Cameron McKenna Nabarro Olswang LLP
(86) International application number: PCT/US2016/012007
(87) International publication number: WO 2016/118306

(56) References cited:
- CN-U- 202 322 711
- JP-A- 2009 099 878
- US-A1- 2007 177 239
- US-A1- 2008 008 216

## Description

### BACKGROUND

A see-through, mixed reality display device system enables a user to observe digital information overlaid on the physical scenery. To enable hands-free user interaction, a see-through, mixed reality display device system may further be equipped with an eye tracker, sensors and displays, all of which are sensitive to misalignment if the optical platform or frame on which they are mounted distorts. Like all devices which include electronic components, the components produce heat which must be redistributed to areas of the device that are not adjacent to the components. This ensures proper component operation and optical platform stability.

US 2007/0177239 A1 (Tanijiri et al.) discloses an image display apparatus of e.g. a head-mounted display. The apparatus comprises a light source including a light-emitting diode mounted on a circuit board, a display element, an eyepiece optical system, a heat absorbing member that is arranged on a side of the circuit board opposite from a side thereof on which the light-emitting diode is mounted, and a heat conducting member. The heat absorbing member absorbs heat generated by the light-emitting diode, and the heat conducting member conducts the heat absorbed by the heat absorbing member to outside a casing. The heat absorbing member and/or the heat conducting member may be formed of metal material.

JP 2009 099878 A describes a heat sink constituted by forming a laminate of a graphite sheet and a metallic thin plate in a corrugated shape, thereby forming fins, and joining the laminate to a heat sink base. The metallic thin plate ensures the rigidity of a fin and transmits heat from the heat sink base to the graphite sheet. Graphite permits to reduce the weight of the heat sink while keeping high heat dissipation performance due to its high heat conductivity.

### SUMMARY

Several aspects of the invention provide a head mounted display as set forth in claim 1. In an example, a technology includes an optical mounting structure adapted for a head mounted display. The structure is configured to support heat producing electronic components on an interior surface, the structure including frame elements having an exterior surface. At least one bonded graphite layer thermally coupled to the electronic components and at least partially mounted to an exterior surface of the optical mounting structure. The graphite may be adhesively bonded to the surface of the mounting structure. Optionally, graphene may be grown or laminated on the surface or pyrolytic graphite may be adhesively bonded to the surface. An optical mounting structure, in accordance with the technology includes a frame region adapted to contain heat producing electronic components and first and second structural components extending away from the frame region. First and second graphite layers are thermally coupled to the electronic components, one of said first and second graphite layers bonded to an exterior surface of each structural component.

This Summary is provided to introduce a selection of concepts in a simplified form that are further described below in the Detailed Description. This Summary is not intended to identify key features or essential features of the claimed subject matter, nor is it intended to be used to limit the scope of the claimed subject matter.

### BRIEF DESCRIPTION OF THE DRAWINGS

Figure 1 is a block diagram depicting example components of an embodiment of a near-eye display (NED) device system.
Figure 2A is a block diagram of example hardware components in a control circuitry embodiment of a NED device.
Figure 2B is a top view of a near-eye display embodiment being coupled with a projection light engine having an external exit pupil.
Figure 3A is a perspective view and Figure 3B is a top view is a second example of a head mounted display embodiment of a near-eye display device system.
Figure 4A is an example of a first thermal management solution including a bonded graphite layer attached to a head mounted display.
Figure 4B is a cross section along lines B -B in Figure 4A.
Figure 5A is an example of the first thermal management solution including a bonded graphite layer attached to another embodiment of a head mounted display.
Figure 5B is a cross section along lines B -B in Figure 5A.
Figure 6A is a top view of a of a head mounted display embodiment of a near-eye display device system illustrating another thermal management solution including a multi-layer graphite stack.
Figure 6B is a cross-section along line B-B in Figure 6A.
Figure 6C is an enlarged view of a multiple graphite layer stack.
Figure 6D is a cross-section of another embodiment of a multi-layer copper/graphene stack.
Figure 7A is a top view of a of a head mounted display embodiment of a near-eye display device system illustrating another thermal management solution including an encased graphite stack structure.
Figure 7B is a cross-section along line B-B in Figure 7A.
Figure 7C is an enlarged view of a first embodiment of an encased multiple graphite layer stack.
Figure 7D is an enlarged view of a second embodiment of an encased multiple graphite layer stack.
Figure 7E is a top view of a of a head mounted display embodiment of a near-eye display device system illustrating an encased graphite stack structure mounted to the exterior of the system.
Figure 7F is a cross-sectional view along line F - F in Figure 7E.
Figure 8 is a perspective view of the first embodiment of the head mounted display device utilizing an embedded and encased graphite stack.
Figures 9 and 10A are top views illustrating another thermal management solution including a buttressed frame structure.
Figure 10B is a cross-sectional view along line B-B in Figure 10A
Figure 11A is a side view of the thermal management solution of Figure 9.
Figure 11B is a cross-section along line B-B in Figure 11A.

### DETAILED DESCRIPTION

The technology provides techniques for thermal management in wearable devices. Technology for thermal management of a wearable device utilized a combination of techniques to remove heat from areas of active components in the device. In one embodiment, the device is a head mounted display. In one embodiment the technology provides a head mounted display including heat-producing electronic components. The display includes an optical mounting structure adapted to include the electronic components on an interior surface, the structure including frame elements having an exterior surface. At least one bonded graphite layer thermally coupled to the electronic components and at least partially mounted to an exterior surface of the optical mounting structure. Optionally, graphene or pyrolytic graphite may be used. An optical mounting structure, in accordance with the technology includes a frame region adapted to contain heat producing electronic components and first and second structural components extending away from the frame region. First and second graphite layers are thermally coupled to the electronic components, one of said first and second graphite layers bonded to an exterior surface of each structural component.

The technology will be described with reference to a see-through head mounted display device, and the issues attending thermal management in such a device. It will be recognized that the thermal management techniques described herein may be expanded to alternative wearable technology, as well as any devices where thermal management using passive heat transfer technology would be useful.

Head-mounted displays, like other high powered computing devices produce large amounts of heat that needs to be quickly and efficiently directed away from the source and dissipated into the environment. This is useful in wearable devices as the surface/skin temperature of the device affects the usability and comfort of the user. There are a number of effective methods for transferring and dissipating heat currently used in the electronics industry. Traditional methods for cooling high powered electronics include passive cooling methods that are generally bulky and heavy and not particularly suitable for being used in wearable devices. In addition, typical materials used in cases (e.g. polycarbonate, LCP) have very poor thermal properties and create inefficiencies in the thermal system as a whole. Improving even small inefficiencies in the thermal system will allow for better device performance and longevity over all.

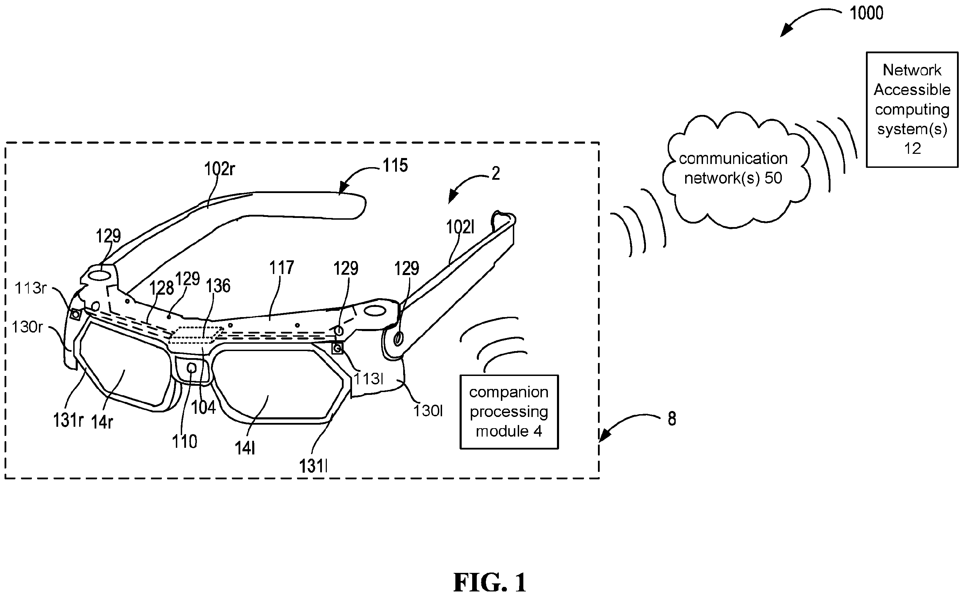

Figure 1 is a block diagram depicting example components of a waveguide display implemented in a Near Eye Display (NED) system 8 including a compact projection light engine and diffractive waveguide. In the illustrated embodiment, a NED device system 8 includes a near-eye display (NED) device in a head-mounted display (HMD) device 2 and companion processing module 4. HMD 2 is communicatively coupled to companion processing module 4. Wireless communication is illustrated in this example, but communication via a wire between companion processing module 4 and HMD 2 may also be implemented. In an embodiment, HMD 2 includes a NED device having a projection light engine 120 and near-eye display 14 having a waveguide.

In this embodiment, HMD 2 is in the shape of eyeglasses having a frame 115, with each display optical system 14l and 14r positioned at the front of the HMD 2 to be seen through by each eye when worn by a user. Each display optical system 14l and 14r is also referred to as a display or near-eye display 14, and the two display optical systems 141 and 14r together may also be referred to as a display or near-eye display 14. In this embodiment, each display optical system 14l and 14r uses a projection display in which image data (or image light) is projected into a user's eye to generate a display of the image data so that the image data appears to the user at a location in a three dimensional FOV in front of the user.

In this embodiment, frame 115 provides a convenient eyeglass frame holding elements of the HMD 2 in place as well as a conduit for electrical and thermal connections. In an embodiment, frame 115 provides a NED device support structure for a projection light engine 120 and a near-eye display 14 as described herein. Some other examples of NED device support structures are a helmet, visor frame, goggles support or one or more straps. The frame 115 includes a nose bridge 104, an optical system structure or housing 131 (including a left side housing 131l and right side housing 131r) joined by the nose bridge 104, a front top cover section 117, a respective projection light engine housing 130 for each of a left side housing (130l) and a right side housing (130r) of HMD 2 as well as left and right temples or side arms 1021 and 102r which are designed to rest on each of a user's ears. In this embodiment, nose bridge 104 includes a microphone 110 for recording sounds and transmitting audio data to control circuitry 136. On the exterior of the side housing 1301 and 130r are respective outward capture devices 113l and 113r (such as cameras) which capture image data of the real environment in front of the user for mapping what is in a FOV of a near-eye display (NED) device. The frame components 115, 117, 104, 130, 131 comprise an optical mounting structure for the display optical systems 14 and the sensors including microphone 110 and cameras 113.

In this embodiment, dashed lines 128 are illustrative examples of some electrical connection paths which connect to control circuitry 136, also illustrated in dashed lines. One dashed electrical connection line is labeled 128 to avoid overcrowding the drawing. The electrical connections and control circuitry 136 are in dashed lines to indicate they are under the front top cover section 117 in this example. As noted in the drawings, the control circuitry and other electronic components such as the displays are mounted to interior surfaces of the optical mounting structure or housing. There may also be other electrical connections (not shown) including extensions of a power bus in the side arms for other components, some examples of which are sensor units including additional cameras, audio output devices like earphones or units, and perhaps an additional processor and memory. Some examples of connectors 129 as screws are illustrated which may be used for connecting the various parts of the frame together.

The companion processing module 4 may take various embodiments. In some embodiments, companion processing module 4 is in a portable form which may be worn on the user's body, e.g. a wrist, or be a separate portable computing system like a mobile device (e.g. smartphone, tablet, laptop). The companion processing module 4 may communicate using a wire or wirelessly (e.g., WiFi, Bluetooth, infrared, an infrared personal area network, RFID transmission, wireless Universal Serial Bus (WUSB), cellular, 3G, 4G or other wireless communication means) over one or more communication network(s) 50 to one or more network accessible computing system(s) 12, whether located nearby or at a remote location. In other embodiments, the functionality of the companion processing module 4 may be integrated in software and hardware components of HMD 2.

Image data is identified for display based on an application (e.g. a game or messaging application) executing on one or more processors in control circuitry 136, companion processing module 4 and/or network accessible computing system(s) 12 (or a combination thereof) to provide image data to near-eye display 14.

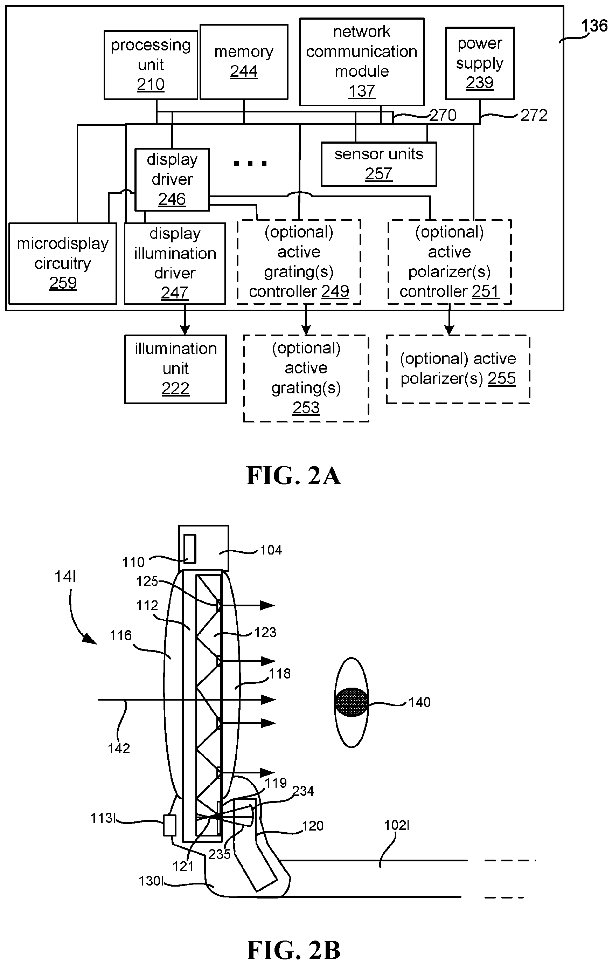

Figure 2A is a block diagram of example hardware components including a computing system within control circuitry of a NED device. Control circuitry 136 provides various electronics that support the other components of HMD 2. In this example, the control circuitry 136 for a HMD 2 comprises a processing unit 210, a memory 244 accessible to the processing unit 210 for storing processor readable instructions and data. A network communication module 137 is communicatively coupled to the processing unit 210 which can act as a network interface for connecting HMD 2 to another computing system such as the companion processing module 4, a computing system of another NED device or one which is remotely accessible over the Internet. A power supply 239 provides power for the components of the control circuitry 136 and the other components of the HMD 2 like the capture devices 113, the microphone 110, other sensor units, and for power drawing components for displaying image data on near-eye display 14 such as light sources and electronic circuitry associated with an image source like a microdisplay in a projection light engine.

The processing unit 210 may comprise one or more processors (or cores) such as a central processing unit (CPU) or core and a graphics processing unit (GPU) or core. In embodiments without a separate companion processing module 4, processing unit 210 may contain at least one GPU. Memory 244 is representative of the various types of memory which may be used by the system such as random access memory (RAM) for application use during execution, buffers for sensor data including captured image data and display data, read only memory (ROM) or Flash memory for instructions and system data, and other types of nonvolatile memory for storing applications and user profile data, for example. Figure 2A illustrates an electrical connection of a data bus 270 that connects sensor units 257, display driver 246, processing unit 210, memory 244, and network communication module 137. Data bus 270 also derives power from power supply 239 through a power bus 272 to which all the illustrated elements of the control circuitry are connected for drawing power.

Control circuitry 136 further comprises a display driver 246 for selecting digital control data (e.g. control bits) to represent image data that may be decoded by microdisplay circuitry 259 and different active component drivers of a projection light engine (e.g. 120 in Figure 2B). A microdisplay, such as microdisplay 230 shown in Figure 3C, may be an active transmissive, emissive or reflective device. For example, a microdisplay may be a liquid crystal on silicon (LCoS) device requiring power or a micromechanical machine (MEMs) based device requiring power to move individual mirrors. An example of an active component driver is a display illumination driver 247 which converts digital control data to analog signals for driving an illumination unit 222 which includes one or more light sources, such as one or more lasers or light emitting diodes (LEDs). In some embodiments, a display unit may include one or more active gratings 253, such as for a waveguide, for coupling the image light at the exit pupil from the projection light engine. An optional active grating(s) controller 249 converts digital control data into signals for changing the properties of one or more optional active grating(s) 253. Similarly, one or more polarizers of a projection light engine may be active polarizer(s) 255 which may be driven by an optional active polarizer(s) controller 251. The control circuitry 136 may include other control units not illustrated here but related to other functions of a HMD 2 such as providing audio output, identifying head orientation and location information.

Figure 2B is a top view of an embodiment of a near-eye display 14l being coupled with a projection light engine 120 having an external exit pupil 121. In order to show the components of the display optical system 14, in this case 14l for the left eye, a portion of the top frame cover 117 covering the near-eye display 141 and the projection light engine 120 is not depicted. Arrow 142 represents an optical axis of the near-eye display 14l.

In this embodiment, the near-eye displays 14l and 14r are optical see-through displays. In other embodiments, they can be video-see displays. Each display includes a display unit 112 illustrated between two optional see-through lenses 116 and 118 and including a waveguide 123. The optional lenses 116 and 118 are protective coverings for the display unit. One or both of them may also be used to implement a user's eyeglass prescription. In this example, eye space 140 approximates a location of a user's eye when HMD 2 is worn. The waveguide directs image data in the form of image light from a projection light engine 120 towards a user's eye space 140 while also allowing light from the real world to pass through towards a user's eye space, thereby allowing a user to have an actual direct view of the space in front of HMD 2 in addition to seeing an image of a virtual feature from the projection light engine 120.

In some embodiments, a waveguide 123 may be a diffractive waveguide. Additionally, in some examples, a waveguide 123 is a surface relief grating (SRG) waveguide. An input diffraction grating 119 couples an image light from a projection light engine 120. Additionally, a waveguide has a number of exit gratings 125 for an image light to exit the waveguide in the direction of a user's eye space 140. One exit grating 125 is labeled to avoid overcrowding the drawing. In this example, an outermost input diffraction grating 119 is wide enough and positioned to capture light exiting a projection light engine 120 before the light exiting the projection light engine has reached its exit pupil 121. The optically coupled image light forms its exit pupil in this example at a central portion of the waveguide.

Figure 2B shows half of a HMD 2. For the illustrated embodiment, a full HMD 2 may include another display optical system 14 with another set of optional see-through lenses 116 and 118, another waveguide 123, as well as another projection light engine 120, and another of outward facing capture devices 113. In some embodiments, there may be a continuous display viewed by both eyes, rather than a display optical system for each eye. In some embodiments, a single projection light engine 120 may be optically coupled to a continuous display viewed by both eyes or be optically coupled to separate displays for the eyes. Additional details of a head mounted personal A/V apparatus are illustrated in United States Patent Application Serial No. 12/905952 entitled Fusing Virtual Content Into Real Content, Filed October 15, 2010.

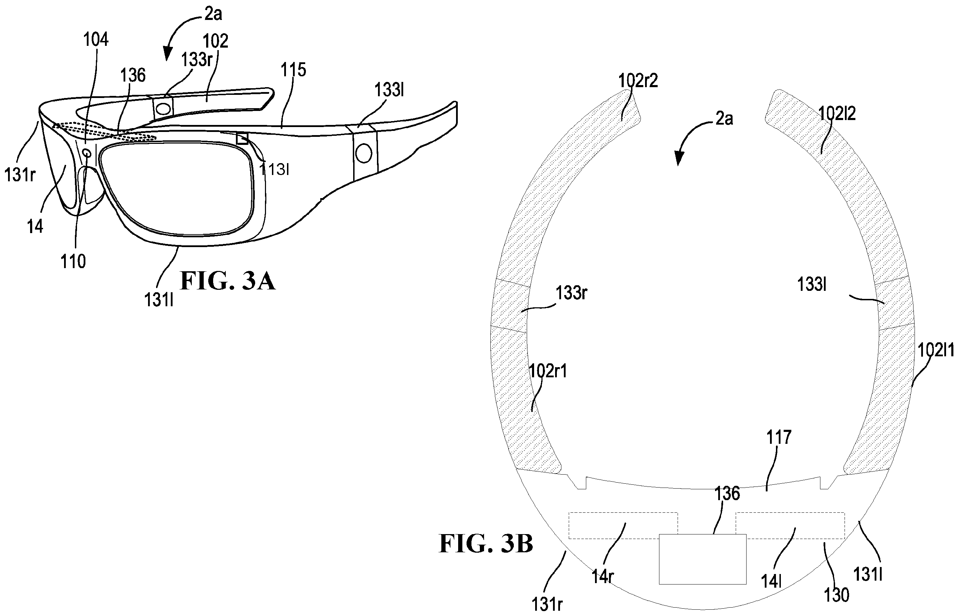

Figures 3A and 3B an alternative embodiment of the HMD layout and frame structure. Like numerals for the embodiment the representations of Figures 3A and 3B represent like parts to those parts illustrated in the embodiment of Figures 1 - 2. Figure 3A is a perspective view and Figure 3B a top view of an HMD 2a.

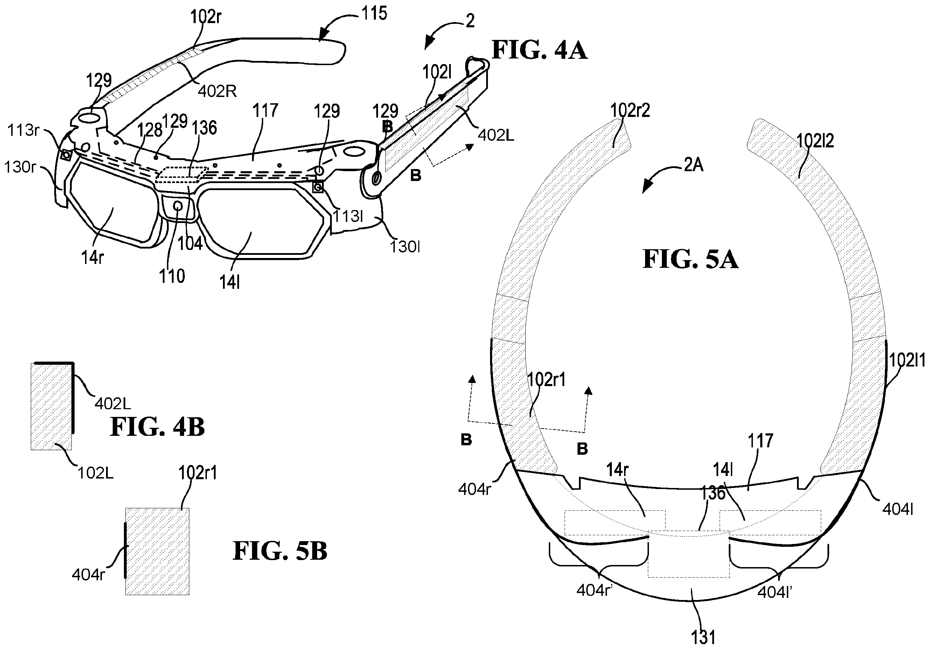

In the embodiment of Figure 3A and 3B, frame 115 may by generally referred to as a wraparound-type frame, where the display optical systems 14 are integrated or mounted into a polymer, plastic or composite frame material comprising elements 110, 131, 102. The temple or side arms 102 may be created to wrap around the head of a wearer and rest on the wearer's ears. In one embodiment, the temples are created by a forward component 102r1 and 102l1 and a rear component 102r2 and 102l2. A mechanical adjustment 133r, 133l may be provide between the forward and rear portions of temples 102. In an alternative embodiment, the temples or side arms 102 may be continuous. Control circuity 136 is located to be in a similar position in the embodiment of Figure 3 and 4 with respect to the embodiment of Figures 1 and 2.

Those skilled in the art will readily understand that electronic components and circuitry utilized in the systems 2 and 2a operate more efficiently when cooling takes place between the circuits and the ambient environment. In a system 2 and 2a, cooling components may raise ambient temperatures of the structural components to a temperature higher than the ambient but insufficient for a wearer to notice. For example, an exemplary temperature range imperceptible to a human wearer would be less than 50 deg. F.

In order to provide passive heat dissipation, various techniques and combinations thereof may be utilized.

### NANOCARBON INFUSED FRAME ELEMENTS

In one embodiment, carbon nanoparticles are mixed with the frame material to provide efficient passive heat transfer within the device frame 115 including framecomponents 102, 130 131, 110, and 115. The carbon nanoparticles increase the thermal conduction properties of the frame elements and provide a lightweight way of increasing the thermal conduction of a base material such as a polymer used to create the frame. A number of heat emitting electrical components, such as the control circuitry and power supplies discussed above, are included in the device. The techniques discussed herein provide various means for removing heat from the heat emitting electrical components in a wearable device.

Carbon nanoparticles, nanodots or nanopowder may comprise spherical high surface area graphitic carbon. Carbon nanoparticles may comprise graphene, and in particular single layer graphene (SLG), bilayer graphene (BLG), few layer graphene (FLG), multilayer graphene (MLG) carbon nanotubes, pyrolytic graphite flakes or any other nanocarbon geometries. Carbon nanoparticles may range in size from 10 - 100 nanometers (nm) in diameter with a specific surface area in the 2 - 50 m2/g. Carbon nano-particles are available in passivated and high purity, and coated and dispersed forms.

Frames such as those illustrated in Figures 1 - 3B may be formed of molded polymers from any of a number of thermoplastic polymers, including, for example acrylonitrile butadiene styrene plastic (Acrylonitrile Butadiene Styrene, ABS), which has a high degree of rigidity and plasticity characteristics. Plastic is plasticized styrene (Polymerising Styrene), propylene (Acrylonitrile) and polybutadiene (Polybutadiene) mixed into butadiene rubber (Latex). The base material may have added thereto and amount of 2 - 10% loading by volume of carbon nanoparticles, nanopowder, pyrolytic graphite flakes or carbon nanotubes. Adding the carbon material to the material matrix prior to formation process for components 102, 130, 131 improves the thermal conductivity of each of the components. In the process, the carbon nanoparticles can be added simultaneously additives such as stabilizers, lubricants and coloring materials. It will be appreciated that any suitable polymer material which may be formed into a desired shape and which when cooled provides a suitable rigidity to ensure stability for the optical platform (display systems 14) under various wearable conditions can be used. The percentage by concentration of the carbon nanoparticles may be in a range of 2 to 10% and in a range of 2 - 4% loading by volume.

The nanocarbon infused structural components may be used in conjunction with any of the later described thermal management techniques described herein.

Formation of frame parts in accordance with a method of the present technology includes the use of injection molding and extrusion molding techniques to form the molded parts for the frame 115. In order to create a part such as temple 102r or 102 r1, an injection molding process includes steps of: (1) providing an injection molding apparatus; (2) mixing the base polymer pellets or powder comprising the fame material and carbon microparticles uniformly; (3) obtaining the mixture from step (2) and adding the mixture to the injection molding apparatus including a heating cylinder; (4) melting the mixture at high temperature to create a molten mixture; (5) injecting the molten mixture through an injection nozzle into a closed mold cavity; (6) and cooling the molten mixture in a mold to solidify the desired component. An extrusion process includes (1) providing a extrusion molding device; (2) mixing the engineering polymer pellets or powder comprising the fame material and carbon nanosphere particles uniformly; (3) obtaining the mixture; (4) melting the mixture at high temperature; and (4) forming a molten mixture through a die; and cooling the molten mixture in a mold to solidify the desired part.

In accordance with the present technology, at least temples 102r1 and 102l may be formed of nanocarbon infused materials. In a further embodiment with respect to HMD 2a, at least elements 102r1 and 102l1 are formed of nanocarbon infused materials. It will be readily understood that any of the components 102, 117, 130, 131 may be formed of nanocarbon infused materials. In a further embodiment, elements 102r2 and 10212 are formed of nanocarbon infused materials.

In alternative embodiments, the carbon nanoparticles may comprise pyrolytic graphite flakes or carbon nanotubes. In any embodiment, the frame may comprise a polycarbonate with a 2%-4% loading by volume of mono-layer graphene flakes with a very large aspect ratio to replace glass-filled polycarbonate. The current material is being used for its robustness, strength and ability to be injection molded. The graphene doped polymer possesses all the same increased properties mechanically, but also boasts a high increase in thermal properties. The increased thermal conductivity of the doped polymer will allow for better heat spreading on the surface on the device, resulting in lower touch temperatures as well as more efficient thermal dissipation from the electronics and display.

Graphene doped polymers, unlike other filled polymers, also create electrically conductivity. As such, the amount of graphene and type (shape-factor, size of flakes, number of atomic layers, aspect ratio, etc.) can be custom tailored to meet the needs of the product and sub-assemblies with respect to EMI shielding.

### BONDED GRAPHITE LAYER

A further embodiment of the present technology utilizes graphite or graphene thermal pseudo-heat pipe to remove heat from the active circuitry 136. Figures 4A - 5B represent an embodiment of a wearable device utilizing the present technology.

Graphites possess anisotropic structures and thus exhibit or possess many properties that are highly directional e.g. thermal and electrical conductivity and diffusion. Graphites are made up of layer planes of hexagonal arrays or networks of carbon atoms. These layer planes of hexagonally arranged carbon atoms are substantially flat and are oriented or ordered so as to be substantially parallel and equidistant to one another. The substantially flat, parallel equidistant sheets or layers of carbon atoms, usually referred to as graphene layers or basal planes, are linked or bonded together and groups thereof are arranged in crystallites. As used herein, the term "graphene" or "graphene film" denotes the atom-thick carbon sheets or layers that stacks up to form cleavable layers (or mica-like cleavings) in graphite.

Graphite may be made up of a plurality layers or planes. A heat sink design can be a complex task requiring extensive math-finite element analysis, fluid dynamics, etc. In designing heat sinks, various factors are taken into consideration, including thermal resistance, area of the heat sink, and the shape of the heat sink.

Some types of graphite, such as pyrolytic graphite, are available in a sheet form, which has a high thermal conductivity in the plane of the sheet and a lower thermal conductivity perpendicular to the plane of the sheet. In one form, the pyrolytic graphite is oriented such that the high-conductivity plane lies parallel to the direction of heat transfer (away from the active circuitry 136 and toward the ends of temples 102.

In one embodiment, a graphite layer contacts at least a portion of the active circuitry 136 and is routed to an exterior portion of the frame 115. As used herein, the term "graphite layer" refers to at least one graphene layer. A graphite layer may in some embodiments comprise a sheet of pyrolytic graphite.

Figure 4A illustrates an attached graphite layer 402 (comprising a left side layer 402l and right side layer 402r) provided on the HMD 2 in the embodiment of Figure 1. Figure 4B is a cross-section of the graphite layer 402 applied to the temples 102 of the frame 115. It will be understood that a thermal coupling of graphite or another thermally conductive material may be routed from the circuitry 136 to the graphite layer 402. As seen in the cross-section of Figure 4B, the layer may be applied to the side of the temples 102 and/or to the top of the temple. Other configurations of the graphite layer 402 will be understood to be within the scope of the present technology, including providing the layer 402 on three sides of the frame and providing the layer 402 on all four sides of the frame. The technology is not limited to the shape of the frame, nor the particular nature of the wearable device.

Figure 5A illustrates an attached graphite layer 404 utilized in the HMD 2A. As illustrated therein, graphite layer 404 (comprising a left side layer 404l and right side layer 404r) are attached to temples 102 (and in particular portions 102l1 and 102r1, respectively). A portion 404r' and 404l' of each graphite layer engages circuitry 136, with the layer attached to the exterior of the temples 102l1 and 102r1. As illustrated in Figure 5b, the graphite layer 404 is secured to the exterior wall of each temple (in this view, temple 102r1).

In one embodiment, the graphite layer may comprise pyrolytic graphite. Pyrolytic graphite is a form of graphite manufactured by using a raw material of a highly crystalline polymer. The polymer is put through a pyrolysis process devoid of oxygen. Not having oxygen keeps combustion from occurring and instead all the volatiles present in the polymer chains are released and resulting in a base structure of carbon rings. High temperature and pressure annealing then occurs to wedge those polymer backbones of carbon into a layered sheet structure viable for high thermal conductivity. The material is grown onto a substrate giving it a layered composition and may have different properties in different planes. Commercially available pyrolytic graphite is available in conductivities ranging from 700W/mk to 2000W/mK and in sheet thicknesses ranging from 10 - 150 µm.

It should be understood that "pyrolythic graphite" may include "thermal pyrolytic graphite" as well as "highly oriented pyrolytic graphite", and "compression annealed pyrolytic graphite," referring to graphite materials consisting of crystallites of considerable size, the crystallites being highly aligned or oriented with respect to each other and having well ordered carbon layers or a high degree of preferred crystallite orientation, with an in- plane (a-b direction) thermal conductivity greater than 1,000 W/m-K. In one embodiment, the TPG has an in-plane thermal conductivity greater than 1,500 W/m-K

The graphite layer may be selected from any material having a high thermal conductivity including pyrolytic graphite, thermal pyrolytic graphite, compression annealed pyrolytic graphite, thermal pyrolytic graphite, highly ordered pyrolytic graphite, pyrolytic graphite, and the like.

In one embodiment, the graphite layer is attached to the temples 102 using a suitable adhesive material. In one embodiment, it is desirable to attach the graphite under constraints which would not adversely affect the sensitive components of the electronics or sensors, nor the mechanical stability of the frame. Because the components (such as cameras 113 and microphone 110 may be sensitive to misalignment if frame 115 becomes mechanically distorted, post-processing of the frame 115 to apply the graphite layer may adversely affect the performance of the device 2/2a.

Graphite layers 402, 404 may be secured to HMDs 2/2A using any suitable form of adhesive to bond the graphite layer to the material comprising the frame elements. Suitable adhesive materials include, for example, inorganic and organic adhesives. An exemplary adhesive material is an epoxy. In one embodiment, the bonding material exhibits thermal conductivity properties, e.g., a thermally conductive epoxy. Acrylic adhesives may also be utilized.

Suitable graphite layers include pyrolytic graphite sheets available from Panasonic Corporation. Such sheets may include applications with or without acrylic adhesives and adhesive tapes.

In one embodiment, the graphite layer may be preformed into a shape suitable for application to the frame elements and which may be thermally connected to the control circuitry 136 or other electronic components of an HMD.

In another alternative, graphene may be grown or laminated on one or more surfaces of the frame. Graphene may be applied by any of a number of methods, including by chemical vapor deposition (CVD), SiC thermal decomposition, or a graphene oxide reduction. In a CVD method, a film comprising graphene is formed on one surface of a substrate (which may comprise a portion of the frame) the graphene film tailored for the particular use by the process chosen.

### NANOCARBON INFUSED FRAME WITH GRAPHITE LAYER

A further embodiment of the present technology includes the use of nanocarbon infused frame elements with an applied graphite layer.

The combination of the graphite layer in conjunction with the nanocarbon infused material increases the thermal conduction properties of the frame 115. It will be readily understood that any of the components 102, 117, 130, 131 may be formed of nanocarbon infused materials.

In accordance with the present technology, at least temples 102r and 102l may be formed of nanocarbon infused materials and have applied thereto a graphite layer in accordance with the foregoing embodiments wherein the graphite layer bonds to a surface of the temple 102l1 and 102r1. In a further embodiment, elements 102R2 and 102L2 are formed of nanocarbon infused materials.

Graphite layers 402, 404 may be secured each other using any suitable form of adhesive to bond the graphite layers to each other, and the stack to the material comprising the frame elements. Suitable adhesive materials include, for example, the inorganic and organic adhesives provided above including epoxy. In one embodiment, the bonding material exhibits thermal conductivity properties, e.g., a thermally conductive epoxy. Acrylic adhesives may also be utilized. Suitable graphite layers include any of the pyrolytic graphite materials discussed herein and may include pyrolytic graphite sheets available from Panasonic Corporation. Such sheets may include applications with or without acrylic adhesives and adhesive tapes. In one embodiment, the adhesives used are curable at ambient temperatures in a range of 60 - 80 degrees Fahrenheit.

It will be understood that the application of a graphite layer in combination with the nanocarbon infused frame elements may further be enhanced by use of any of the below thermally conductive graphite structures described herein.

In order to create a part such as temple 102r or 102 r1, use of the injection molding and/or extrusion process discussed above may be utilized. Following the aforementioned cooling steps, the graphite layer may be applied to the desired location of the part by (1) forming the graphite layer into a suitable shape for application to the part surface, (2) applying one of the aforementioned adhesives to the frame element in a contact region; (3) applying the graphite layer and (4) applying a uniform pressure to the graphite layer to allow curing of the adhesive to secure the layer to the part.

### GRAPHITE LAYER STACK

A further embodiment of the present technology includes the use a multi-layer stack of graphite layers constructed to be applied to the surface of the elements. Construction of a multi-layer stack of graphite sheets may provide a thermal highway which can be attached to components of the HMD 2/2a.

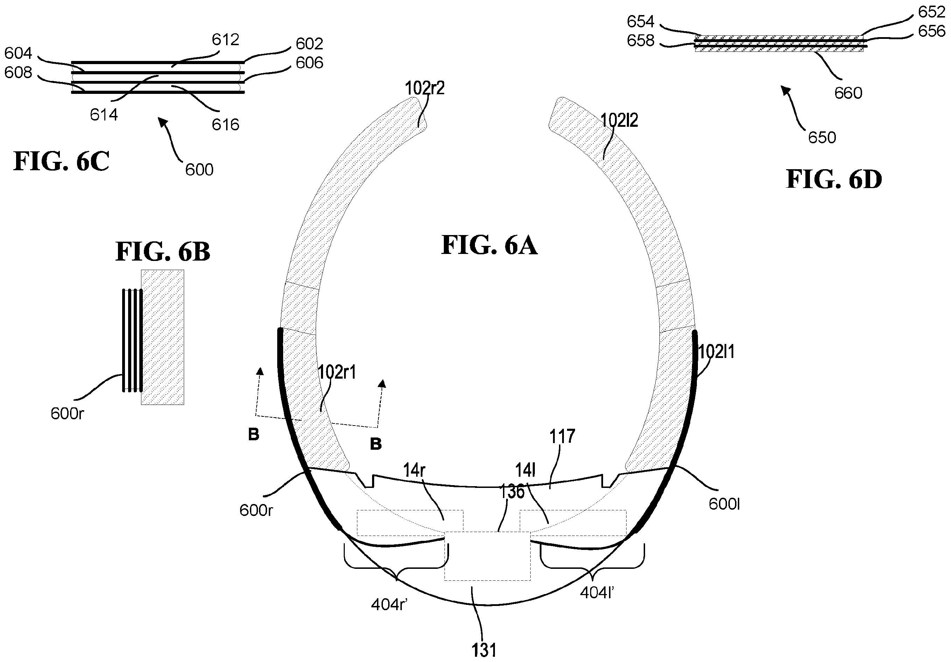

Figures 6A - 6C illustrates use of the multilayer stack in conjunction with the graphite layer thermally coupled to the active circuitry 136. Figure 6A illustrates one configuration of the multiple graphite layer stack in accordance with the technology applied to frame elements of an HMD device and thermally coupled to active circuits in HMD 2a. In Figure 6A, two stacks 600r and 6001 are illustrated

A representation of a multilayer stack of graphite layers is illustrated in Figure 6C. In Figure 6C, individual graphite layers 602 - 608 are secured to and sandwich adhesive layers 612 - 616. While four graphite layers are illustrated, any number of graphite and adhesive layers may be utilized to make stack 600.

One difficulty in assembling stack 602 is that graphite layers by nature not wish to adhere to each other. In addition, granites may be tear sensitive, and the structure can be brittle when applied to the exterior of a frame which can be exposed to ambient conditions. Suitable adhesive materials include, for example, inorganic and organic adhesives. An exemplary adhesive material is an epoxy. In one embodiment, the bonding material exhibits thermal conductivity properties, e.g., a thermally conductive epoxy. Acrylic adhesives may also be utilized. Suitable graphite layers include any of the pyrolytic graphite materials discussed herein. The graphite stack 602 can be formed into any of a number of three-dimensional shapes by configuring the graphite layers assembled into the stack.

In one embodiment, a stack 600 is not coupled by portions 404r' and 404l' to the active circuitry 136, but is attached to any one or more of the surfaces of the frame components such as temples 102, cover section 117, and housing 131.

It will be understood that the application of a graphite layer stack may be utilized in combination with the nanocarbon infused frame elements discussed above.

In order to create a part such as temple 102l1 or 102r1, use of the injection molding and/or extrusion process discussed above may be utilized. Prior to formation of the part or thereafter, a multi-layer stack is created by creating the multilayer stack 600 including (1) forming the graphite layers into a suitable shape to be applied to the surface of a frame element; (2) applying adhesive to a first of the graphite layers followed by (3) applying a second graphite layer on the adhesive; (4) applying uniform pressure to the graphite layer; and (optionally) (5) repeating steps (1) - (3) for any number of additional layers. Alternatively, steps (1) - (3) may be repeated for any number of layers prior to applying uniform pressure to the outermost layer in the stack. Thereafter, the stack 600 is applied to a frame part using any of the aforementioned adhesives discussed herein. The part may be created with any of the materials discussed herein and any of the aforementioned part fabrication processes, with or without infused nanocarbon in the part material.

A thermal coupling structure of graphite (such as region 404r') may be incorporated during stack formation or glued to the stack 600 thereafter.

Although the graphite layer is illustrated in a particular configuration in Figures 6A - 6C, the layers may be provided in any of a number of regions on the device. Any surface of the temples 102 may include a graphite layer (whether coupled to a thermal coupling or attached to the device to promote heat transfer away from any active components).

In some embodiments, the resulting structure is a flexible structure that can be molded to a surface of the frame, as illustrated, or used in any of a number of applications. The flexibility of the structure and the thermal performance of the structure depends on the bonding layers between the graphite layers.

An alternative embodiment of a graphite layer structure may be formed as a copper-graphene structure 650. In this embodiment, a central, planer sheet of copper 656 having a thickness ranging from 20-50µm is coated on both sides with layers of graphene 654, 658 after which coper layers 652, 660 are applied to respective graphene layers 654, 658. The graphene may be formed by any of the aforementioned processes and layers 652 and 660 of copper may be deposited by a suitable vapor or physical deposition process.

### ENCASED GRAPHITE LAYER STACK

A further embodiment of the present technology includes the use a multi-layer stack of graphite layers constructed within a metallic enclosure which may be thermally connected to active circuitry and thereafter applied to the surface of frame elements to act as a passive pseudo-heat pipe.

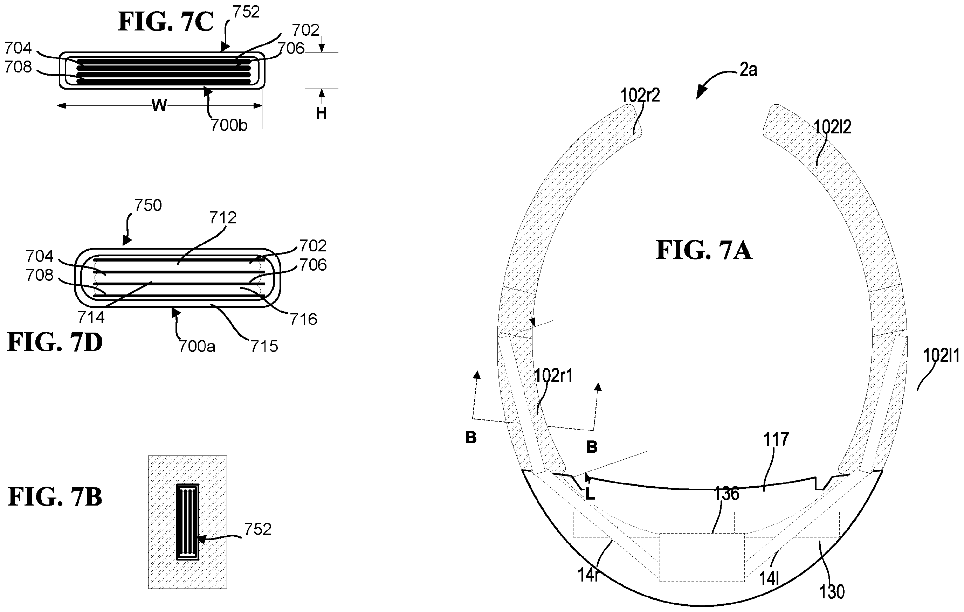

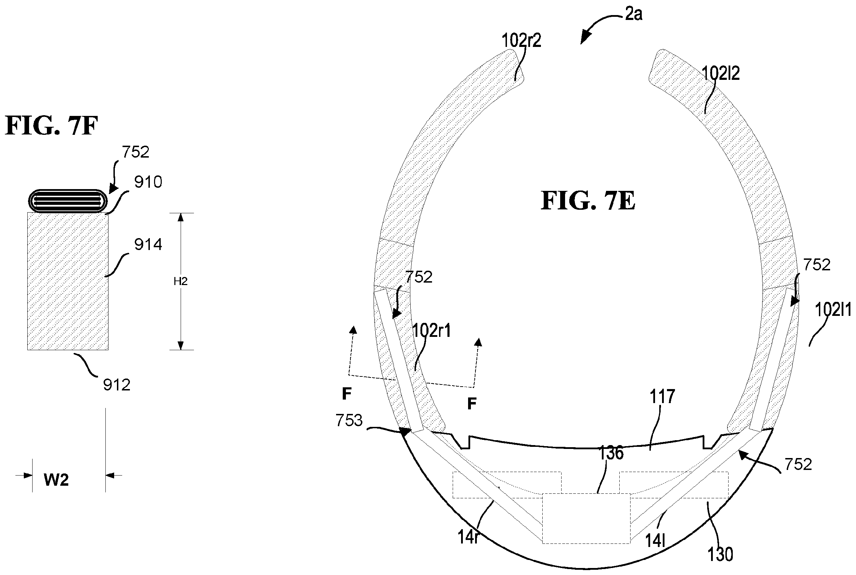

Figures 7 - 8 illustrate a multilayer stack of graphite constructed in an enclosed metallic casing. In one embodiment illustrated in Figure 7D, an encased assembly 750 including the graphite stack 700a may have a structure similar to graphite stack 600 illustrated above. This embodiment, plurality layers 702 through 708 are joined by adhesives 712 - 716 after which the stack 700a is encased in a metallic layer or coating. Figure 7C illustrates an alternative embodiment of an encased assembly 750 including stack 700b wherein no adhesive is used between the multiple graphite layers. In the embodiment of Figure 7C, direct contact between the layers 702 - 708 and the casing material ensures thermal conduction.

The embodiment of Figure 7D may be created by: (1) forming a first graphite layer into a suitable shape to be applied to the surface of a frame element; (2) applying adhesive to a first of the graphite layers followed by (3) applying a second graphite layer on the adhesive; (4) applying uniform pressure to the graphite layer; and (optionally) (5) repeating steps (1) - (3) for any number of additional layers. Alternatively, steps (1) -(3) may be repeated for any number of layers prior to applying uniform pressure to the outermost layer in the stack. After creation of stack 700a, the stack is encased in a metallic casing 715. The casing 715 is preferably made of a high conductivity metal such as titanium, copper, tin, nickel, silver, aluminum, TiW (90/10, and other alloys), copper tin alloys, and alloys of the above metals). The casing extends around and encloses the pyrolytic graphite stack so that the pyrolytic graphite stack is embedded within the casing. In one embodiment, the casing is hermetic, so that no external agents can penetrate to contact the stack. The casing may be applied by metallic deposition techniques or formed by mechanically manipulating workable forms of the aforementioned metals to encase the stack 700a.

The embodiment of Figure 7C may be created by: (1) forming a selected number of the graphite layers to be formed into the stack into a suitable shape to be applied to the frame element; (2) providing the graphite layers and the coating material in a vacuum environment; (3) stacking successive graphite layers into a stack 700b; (4) applying uniform pressure to the graphite layers; and encasing the graphite layers in the stack using one of (a) metallic deposition onto the stack or (b) mechanical manipulation of metal plates of sufficient size to surround the stack followed by sealing the casing about the stack 700b.

Suitable graphite layers include any of the pyrolytic graphite materials discussed herein. The graphite material used in the stack should have its high plane of conductivity arranged and oriented perpendicular to the plane of the drawings of Figures 7C and 7D so that when arranged in the device 2, high-conductivity plane lies parallel to the direction of heat transfer (away from the active circuitry 136 and toward the ends of temples 102).

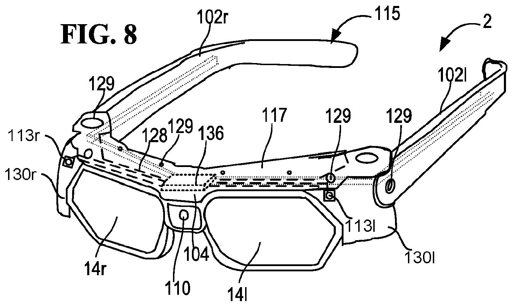

Figure 7A is a top view of the HMD device to a illustrating that the encased graphite layer stack structure can be incorporated into the frame materials of the device. Corporation the frame materials is also illustrated with respect to device two in Figure 8. In this embodiment, the case stack, illustrated in Figures of be, is molded into the frame itself. Figures 7E and 7F illustrate positioning of the encased structure on a top portion of the device two a.

Various configurations of the encased graphite layer stack structure can be utilized in accordance with the teachings of this technology. The structure may have various different three-dimensional forms, an alternative components of the forms may be joined together. As illustrated in Figure 7D, two such structures may be formed in a linear manner and joined together using any of the aforementioned techniques of adhesive, creating the structures from native graphite sheets, or the like.

With respect to Figures 7A and 7C, each encased structure may have a length L, width W and height H defined in accordance with the thermal management objectives of the system. Each of the respective sheets of graphite in the layer stack may be defined and selected to have a plane high thermal conductivity along a first axis and a plane of lower thermal conductivity along a second axis. In one embodiment the plane is selected so that the axis of high conductivity aligns with the length and is parallel to an axis bisecting the length of the encased stack. As noted in Figure 7A, the length is multiple times longer than the width the height less than the width.

Figures 7E and 7F illustrate the encased structure 752 positioned on an exterior surface of an HMD 2a. In the illustration of Figure 7E and 7F, the encased structure 752 is positioned on a top surface 910 of arm 102r1. It should be understood that the structure 752 may be provided on a bottom surface 912 or a side surface 914 of the arm. In addition, Figure 7E illustrates two encased structures 752 joined at an interface 753. Due to the workability of the metal encasing the structure 752, joining of respective structures may occur by thermal bonding such as mechanically connecting, soldering or welding the respective structures 752, or by forming the underlying graphite layers in to an angled structure and thereafter encasing the formed angled structure in a metal coating.

It will be understood that the application of a graphite layer stack may be utilized in combination with the nanocarbon infused frame elements discussed above. In addition, the encased structure may be utilized with the stack 600 described above, alone or in combination therewith.

### BUTTRESSED FRAME STRUCTURE

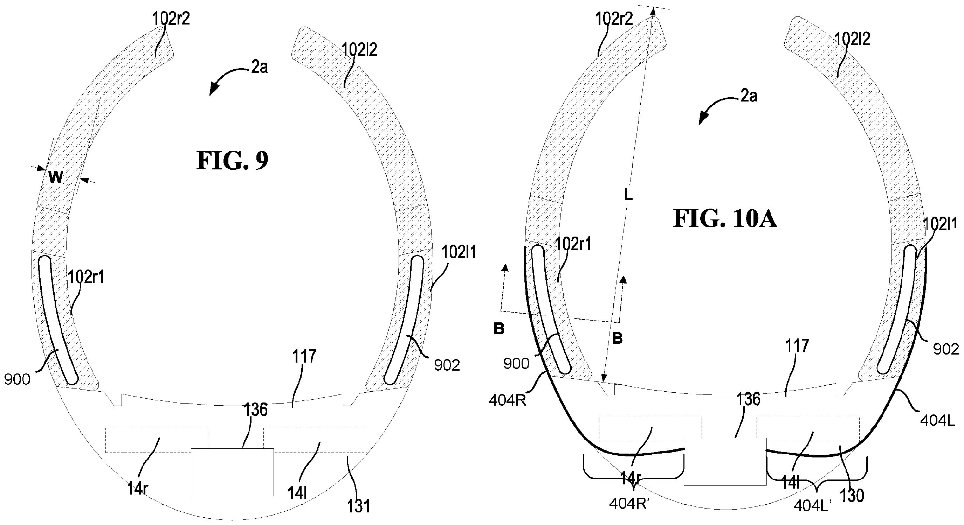

Figures 9 - 11 illustrate an alternative frame structure suitable for use with any of the aforementioned devices 2 and 2a. Although the subject matter will be illustrated with respect to the HMD 2a, it will be recognized that similar techniques can be used with any type of framing structure.

In Figures 9 - 11B, temples 102R1 and 102L1 have been formed to include voids 900, 902, thereby creating arches adjacent the joining points of the temples 102r1 and 101L1 to temples 102R2 and 102L2, respectively, and housing 131. The voids effectively provide a arched temple structure which couples the housing 131 two other portions of the side arms 102L2/102r2. Voids 900, 902 provide an increase in the surface area available for convective and radiant heat transmission to the ambient environment. Any heat provided and transferred from the active circuitry to the temples 102 R1 and 102l1 can be more easily cooled by the ambient environment. In the illustrated embodiment, void 900 includes a first sidewall 912, second sidewall 914 and two arches 916, 918 joining the respective sidewalls

In addition, the voids 900, 902 increase the strength of the temples 102 by using arch construction techniques. An arch is a pure compression form resolving forces into compressive stresses and, in turn eliminating tensile stresses. Given the architecture of HMDs 2/2a, with forward components carrying most of the weight and support components (such as the temples 102) stabilizing the device, strength in the temple components in combination with lightweight constructions is desirable.

Although the voids are illustrated as being provided only in elements 102r1 and 102l1 , it will be understood that the voids may be formed in temple portions 102R2 and 102L2, or in a unitary temple structure such as that provided in the HMD device 2.

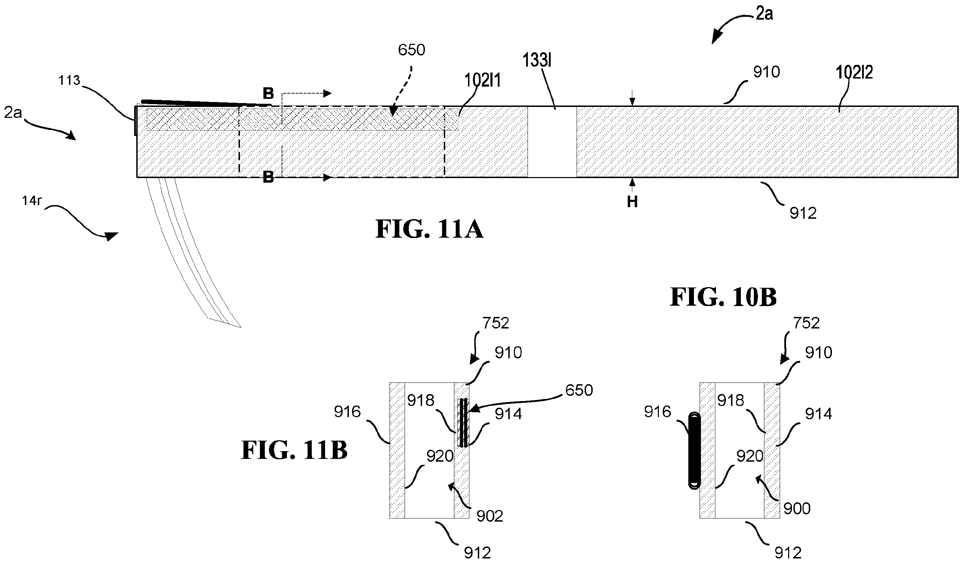

In addition, the void architecture of Figures 9 and 10 a can be utilized with any of the aforementioned thermal management techniques described above.

In particular, the components of the device of Figure 9 may be manufactured of nanocarbon infused materials as described above. Any one or more of the graphite structures discussed above may be attached on the surface of or embedded in the structures of Figure 9.

Figure 10A illustrates an example of using a graphite layers to that described above in Figure 5A in combination with the voids 900, 902. As illustrated therein, a graphite layer 404 is provided as in Figure 5A with portions 404r and 4041 being attached to elements 102r1 and 102l1 having voids therein. Graphite layers 404r and 404l may be a sheet of pyrolytic graphite, any of the graphite stacks illustrated herein, or a laminated layer of graphene.

Figure 10B illustrates a cross-section along line B-B in Figure 10A, showing the top surface 910, bottom surface 912, first side 914 and second side 916 of arm portion 102r1. In addition, the interior walls 918 and 912 are illustrated. It will further be appreciated that graphite layer or layers may be applied to the interior walls 918, 920 of the structure of Figure 10A. In Figure 10B, only void 900 is illustrated, but it should be understood that structure 752 can be provided on both arms 102L and 102r

Figures 11A and 11B illustrate the use of the graphite layer structure 650 described above wherein the structure 650 is encased in the frame 2a. The structure 650 is thermally coupled to the heat producing components and extends into the void regions 900, 902 (In Figures 11A and 11B, only void 902 is illustrated, but it should be understood that structure 650 can be provided on both arms 102l and 102r.)

In addition, the voids formed in components of the frame may take various shapes. The arcuate voids 900, 902 provide convection vertically when the device is worn by a wearer. This can provide convection with cooler air passing through and around the voids and frame element as it rises. However, the voids may be provided horizontally with respect to direction of the temples 102. Moreover, the voids may be provided in any number and shape. For example, a plurality of circular or other shaped bores may be provided in the frame elements

Additional graphite layers may be provided on the interior surfaces of voids 900, 902 or the outer surfaces of the temples 102.

Any one or more of the graphite layers, graphite stacks or encased structures may be embedded in the frame by manufacturing the frame components around the thermal structures. An injection molding process embedding such structures includes steps of: (1) providing an injection molding apparatus; (2) mixing the engineering polymer pellets or powder comprising the fame material and carbon nanosphere particles uniformly; (3) obtaining the mixture from step (2) and adding the mixture to the injection molding apparatus including a heating cylinder; (4) melting the mixture at high temperature; (5) providing the graphite layer, multilayer stack or encased graphite layer stack into a mold cavity and closing the cavity; (6) injecting the molten mixture through an injection nozzle into a closed mold cavity; and (7) cooling the molten mixture in a mold to solidify the desired part. An extrusion process includes (1) providing a extrusion molding device; (2) mixing the engineering polymer pellets or powder comprising the fame material and carbon nanosphere particles uniformly; (3) obtaining the mixture;(4) melting the mixture at high temperature; (4) forming a molten mixture through a die to surround a graphite layer, multilayer stack or encased graphite layer stack; and (5) cooling the molten mixture in a mold to solidify the desired part.

### Aspects of Certain Embodiments

Embodiments of the technology include a head mounted display including heat-producing electronic components. The display includes an optical mounting structure adapted to include the electronic components on an interior surface, the structure including frame elements having an exterior surface, and at least one bonded graphite layer thermally coupled to the electronic components and at least partially mounted to an exterior surface of the optical mounting structure.

Embodiments of the technology include any of the aforementioned embodiments wherein the graphite layer comprises pyrolytic graphite.

Embodiments of the technology include any of the aforementioned embodiments wherein the graphite layer comprises graphene.

Embodiments of the technology include any of the aforementioned embodiments wherein the graphite layer is adhesively bonded to the optical mounting structure.

Embodiments of the technology include any of the aforementioned embodiments wherein each layer has a plane of high thermal conductivity along a first axis and a lower thermal conductivity along a second axis orthogonal to the first axis, each layer having a length and a width where the length is longer than the width, the length having a first end coupled to the electronic components and a second end terminating on said exterior surface, and the first axis aligns parallel to said length.

Embodiments of the technology include any of the aforementioned embodiments wherein the optical mounting structure includes first and second temple arms extending away from the components, each temple arm having a length and a width and a height, and wherein said at least one bonded graphite layer comprises at least a first graphite layer and a second graphite layer each bonded to the electronic components and respectively mounted to an exterior surface of the first temple arm and the second temple arm.

Embodiments of the technology include any of the aforementioned embodiments wherein the optical mounting structure includes a percentage by concentration of carbon nanoparticles.

Embodiments of the technology include any of the aforementioned embodiments incorporating an optical mounting structure, the optical mounting structure comprising: a frame region adapted to contain heat producing electronic components; first and second temple arms extending away from the frame region, each temple arm having a length and a width and a height, and first and second graphite layers thermally coupled to the electronic components, one of said first and second graphite layers bonded to an exterior surface of each temple arm.

Embodiments of the technology include any of the aforementioned embodiments wherein each graphite layer is adhesively bonded to the optical mounting structure using one of an ambient temperature curable epoxy adhesive and an acrylic adhesive.

Embodiments of the technology include any of the aforementioned embodiments wherein each graphite layer has a plane of high thermal conductivity along a first axis and a lower thermal conductivity along a second axis orthogonal to the first axis, each layer having a length and a width where the length is longer than the width, the length having a first end coupled to the electronic components and a second end terminating on said exterior surface, and the first axis aligns parallel to said length.

Embodiments of the technology include any of the aforementioned embodiments wherein each graphite layer comprises a pre-formed portion of a pyrolytic graphite sheet.

Embodiments of the technology include any of the aforementioned embodiments wherein the optical mounting structure includes a percentage by concentration of carbon nanoparticles.

Embodiments of the technology include any of the aforementioned embodiments wherein each temple arm includes a top surface, a bottom surface, a first side surface and a second side surface, each arm including one or more voids extending between the top and bottom surfaces and between the first and second sides at one or more locations along the length of the temple arm, the at least one bonded graphite layer extending from the electronic components to a surface adjacent to the void.

Embodiments of the technology include any of the aforementioned embodiments created by method of providing an optical mounting structure for a head mounted display. The method may comprise providing a frame structure including an interior surface and an exterior surface; securing heat producing electrical components to the interior surface of the frame structure; thermally coupling a layer of graphite to the heat producing electrical components ; and bonding the layer of graphite to the exterior surface of the frame structure.

Embodiments of the technology include any of the aforementioned embodiments wherein said bonding comprises applying an adhesive between the exterior surface and a region of the layer of graphite.

Embodiments of the technology include any of the aforementioned embodiments wherein the applying occurs at an ambient temperature range of between 60 and 80 degrees Fahrenheit.

Embodiments of the technology include any of the aforementioned embodiments further comprising: forming a layer of graphite into a pre-formed thermal pathway having a shape sized to mount on the exterior of the frame structure.

Embodiments of the technology include any of the aforementioned embodiments wherein each graphite layer has a plane of high thermal conductivity along a first axis and a lower thermal conductivity along a second axis orthogonal to the first axis, wherein forming comprises forming the shape such that each layer has a length and a width where the length is longer than the width, the length having a first end adapted to be coupled to heat producing electronic components and a second end adapted to terminate on said exterior surface, and forming said shape such that the first axis aligns parallel to said length.

Embodiments of the technology include any of the aforementioned embodiments wherein the thermally coupling comprises adhesively bonding the layer of graphite to the heat producing electrical components.

Embodiments of the technology include any of the aforementioned embodiments wherein the layer of graphite is formed from a sheet of pyrolytic graphite.

Although the subject matter has been described in language specific to structural features and/or acts, it is to be understood that the subject matter defined in the appended claims is not necessarily limited to the specific features or acts described above. Rather, the specific features and acts described above are disclosed as examples of implementing the claims and other equivalent features and acts that would be recognized by one skilled in the art are intended to be within the scope of the claims.

## Claims

1. A head mounted display (2, 2a) including heat-producing electronic components (136), comprising:
an optical mounting structure (115) adapted to include the electronic components (136) on an interior surface, the structure (115) including frame elements (115, 104, 131, 117, 130, 102) having an exterior surface, wherein the optical mounting structure (115) includes first and second temple arms (102l, 102r) extending away from the components (136), each temple arm (102l, 102r) having a length, a width and a height, and
at least one bonded graphite layer (402, 404) comprising at least a first graphite layer (402l, 404l) and a second graphite layer (402r, 404r) each thermally coupled to the electronic components (136) and respectively mounted to an exterior surface of the first temple arm (1021) and the second temple arm (102r) of the optical mounting structure (115).

2. The display of claim 1 wherein the at least one bonded graphite layer (402, 404) comprises pyrolytic graphite.

3. The display of claim 1 wherein the at least one bonded graphite layer (402, 404) comprises a laminated graphene.

4. The display of claim 1 wherein a sheet of graphite (402l, 402r, 404l, 404r) is adhesively bonded to the optical mounting structure (115).

5. The display of claim 4 wherein the first and second graphite layers (402l, 402r, 404l, 404r) are adhesively bonded to the optical mounting structure (115) using one of an ambient temperature curable epoxy adhesive and an acrylic adhesive.

6. The display of claim 1 wherein each of the first and second graphite layers (402l, 402r, 404l, 404r) has a plane of high thermal conductivity along a first axis and a lower thermal conductivity along a second axis orthogonal to the first axis, each layer (402l, 402r, 404l, 404r) having a length and a width where the length is longer than the width, the length having a first end coupled to the electronic components (136) and a second end terminating on said exterior surface, and the first axis aligns parallel to said length.

7. The display of claim 1 wherein each of the first and second graphite layers (402l, 402r, 404l, 404r) is bonded to the electronic components (136).

8. The display of claim 1 wherein the length of each temple arm (102l, 102r) extends away from the components (136) toward the end of the respective temple arm (102l, 102r), the width of each temple arm (102l, 102r) is perpendicular to its respective length and extends toward the head of a user of the head mounted display (2, 2a), and the height of each temple arm (102l, 102r) is perpendicular to its respective length and width, and
wherein the first graphite layer (402l, 4041) and the second graphite layer (402r, 404r) are respectively applied to a side of the first temple arm (102l) and the second temple arm (102r), the side of a temple arm (102l, 102r) corresponding to an external surface of the temple arm (102l, 102r) extending in the length and the height of the temple arm (102l, 102r).

9. The display of claim 1 wherein the length of each temple arm (102l, 102r) extends away from the components (136) toward the end of the respective temple arm (102l, 102r), the width of each temple arm (102l, 102r) is perpendicular to its respective length and extends toward the head of a user of the head mounted display (2, 2a), and the height of each temple arm (102l, 102r) is perpendicular to its respective length and width, and
wherein the first graphite layer (402l, 404l) and the second graphite layer (402r, 404r) are respectively applied to a top of the first temple arm (102l) and the second temple arm (102r), the top of a temple arm (102l, 102r) corresponding to the external surface of the temple arm (102l, 102r) extending in the length and the width of the temple arm (102l, 102r) and oriented toward the top of the head of the user.

10. A method of providing an optical mounting structure (115) for a head mounted display (2, 2a), comprising:
providing a frame structure (115) including an interior surface and an exterior surface, the frame structure (115) comprising first and second temple arms (102l, 102r);
securing heat producing electrical components (136) to the interior surface of the frame structure (115);
thermally coupling at least one layer of graphite (402, 404) to the heat producing electrical components (136), comprising thermally coupling at least a first graphite layer (402l, 404l) and a second graphite layer (402r, 404r) of the at least one layer of graphite (402, 404) to the heat producing electrical components (136); and
respectively bonding the first graphite layer (402l, 404l) and the second graphite layer (402r, 404r) to an exterior surface of the first temple arm (102l) and the second temple arm (102r) of the frame structure (115).

11. The method of claim 10 wherein said bonding comprises applying an adhesive between the exterior surface and a region of the graphite layer (402l, 402r, 404l, 404r).

12. The method of claim 10 further comprising:
forming the at least one layer of graphite (402, 404) into a pre-formed thermal pathway having a shape sized to mount on the exterior of the frame structure (115).

## Patentansprüche

1. Kopfmontierte Anzeige (2, 2a), einschließend wärmeerzeugende elektronische Komponenten (136), umfassend:
eine optische Montagestruktur (115), die angepasst ist, um die elektronischen Komponenten (136) an einer Innenfläche einzuschließen, wobei die Struktur (115) Rahmenelemente (115, 104, 131, 117, 130, 102) einschließt, die eine Außenfläche aufweisen, wobei die optische Montagestruktur (115) einen ersten und zweiten Brillenbügel (102l, 102r) einschließt, die sich weg von den Komponenten (136) erstrecken, wobei jeder Brillenbügel (102l, 102r) eine Länge, eine Breite und eine Höhe aufweist, und
mindestens eine gebundene Graphitschicht (402, 404), umfassend mindestens eine erste Graphitschicht (402l, 404l) und eine zweite Graphitschicht (402r, 404r), die jeweils an die elektronischen Komponenten (136) thermisch gekoppelt sind und jeweils an einer Außenfläche des ersten Brillenbügels (102l) und des zweiten Brillenbügels (102r) der optischen Montagestruktur (115) montiert sind.

2. Anzeige nach Anspruch 1, wobei die mindestens eine gebundene Graphitschicht (402, 404) pyrolytischen Graphit umfasst.

3. Anzeige nach Anspruch 1, wobei die mindestens eine gebundene Graphitschicht (402, 404) ein mehrschichtiges Graphen umfasst.

4. Anzeige nach Anspruch 1, wobei eine Folie von Graphit (402l, 402r, 404l, 404r) klebend an die optische Montagestruktur (115) gebunden ist.

5. Anzeige nach Anspruch 4, wobei die erste und zweite Graphitschicht (402l, 402r, 404l, 404r) unter Verwendung eines von einem bei Umgebungstemperatur härtbaren Epoxidharzklebstoff und einem Acrylklebstoff klebend an die optische Montagestruktur (115) gebunden sind.

6. Anzeige nach Anspruch 1, wobei jede der ersten und zweiten Graphitschicht (402l, 402r, 404l, 404r) eine Ebene mit hoher Wärmeleitfähigkeit entlang einer ersten Achse und eine mit niedrigerer Wärmeleitfähigkeit entlang einer zweiten Achse, die orthogonal zur ersten Achse ist, aufweist, wobei jede Schicht (402l, 402r, 404l, 404r) eine Länge und eine Breite aufweist, bei der die Länge länger als die Breite ist, wobei die Länge ein erstes Ende, das an die elektronischen Komponenten (136) gekoppelt ist, und ein zweites Ende, das an der Außenfläche endet, aufweist, und die erste Achse parallel zur Länge ausgerichtet ist.

7. Anzeige nach Anspruch 1, wobei jede der ersten und zweiten Graphitschicht (402l, 402r, 404l, 404r) an die elektronischen Komponenten (136) gebunden ist.

8. Anzeige nach Anspruch 1, wobei sich die Länge jedes Brillenbügels (102l, 102r) weg von den Komponenten (136) zum Ende des jeweiligen Brillenbügels (102l, 102r) hin erstreckt, die Breite jedes Brillenbügels (102l, 102r) senkrecht zu ihrer jeweiligen Länge ist und sich zum Kopf eines Benutzers der kopfmontierten Anzeige (2, 2a) hin erstreckt, und die Höhe jedes Brillenbügels (102l, 102r) senkrecht zu ihrer jeweiligen Länge und Breite ist, und
wobei die erste Graphitschicht (402l, 404l) und die zweite Graphitschicht (402r, 404r) jeweils auf eine Seite des ersten Brillenbügels (102l) und des zweiten Brillenbügels (102r) aufgetragen werden, wobei die Seite eines Brillenbügels (102l, 102r), die einer Außenfläche des Brillenbügels (102l, 102r) entspricht, sich in der Länge und der Höhe des Brillenbügels (102l, 102r) erstreckt.

9. Anzeige nach Anspruch 1, wobei sich die Länge jedes Brillenbügels (102l, 102r) weg von den Komponenten (136) zum Ende des jeweiligen Brillenbügels (102l, 102r) hin erstreckt, die Breite jedes Brillenbügels (102l, 102r) senkrecht zu ihrer jeweiligen Länge ist und sich zum Kopf eines Benutzers der kopfmontierten Anzeige (2, 2a) hin erstreckt, und die Höhe jedes Brillenbügels (102l, 102r) senkrecht zu ihrer jeweiligen Länge und Breite ist, und
wobei die erste Graphitschicht (402l, 404l) und die zweite Graphitschicht (402r, 404r) jeweils auf einen oberen Teil des ersten Brillenbügels (102l) und des zweiten Brillenbügels (102r) aufgetragen werden, wobei der obere Teil eines Brillenbügels (102l, 102r), der der Außenfläche des Brillenbügels (102l, 102r) entspricht, sich in der Länge und der Breite des Brillenbügels (102l, 102r) erstreckt und zum oberen Teil des Kopfes des Benutzers hin orientiert ist.

10. Verfahren zum Bereitstellen einer optischen Montagestruktur (115) für eine kopfmontierte Anzeige (2, 2a), umfassend:
Bereitstellen einer Rahmenstruktur (115), einschließend eine Innenfläche und eine Außenfläche, wobei die Rahmenstruktur (115) einen ersten und zweiten Brillenbügel (102l, 102r) umfasst;
Befestigen von wärmeerzeugenden elektrischen Komponenten (136) an der Innenfläche der Rahmenstruktur (115);
thermisches Koppeln mindestens einer Schicht von Graphit (402, 404) an die wärmeerzeugenden elektrischen Komponenten (136), umfassend thermisches Koppeln mindestens einer ersten Graphitschicht (402l, 404l) und einer zweiten Graphitschicht (402r, 404r) der mindestens einen Schicht von Graphit (402, 404) an die wärmeerzeugenden elektrischen Komponenten (136); und
Binden der ersten Graphitschicht (402l, 404l) und der zweiten Graphitschicht (402r, 404r) jeweils an eine Außenfläche des ersten Brillenbügels (102l) und des zweiten Brillenbügels (102r) der Rahmenstruktur (115).

11. Verfahren nach Anspruch 10, wobei das Binden ein Auftragen eines Klebstoffs zwischen der Außenfläche und einem Bereich der Graphitschicht (402l, 402r, 404l, 404r) umfasst.

12. Verfahren nach Anspruch 10, weiter umfassend:
Formen der mindestens einen Schicht von Graphit (402, 404) zu einem vorgeformten Wärmepfad, der eine Form aufweist, die ausgelegt ist, um an der Außenseite der Rahmenstruktur (115) montiert zu werden.

## Revendications

1. Appareil d'affichage (2, 2a) monté sur la tête comprenant des composants électroniques producteurs de chaleur (136), comprenant :
une structure de montage optique (115) qui est à même d'inclure des composants électroniques (136) sur une surface interne, la structure (115) comprenant des éléments de châssis (115, 104, 131, 117, 130, 102) ayant une surface externe, dans lequel la structure de montage optique (115) comprend un premier et un second bras de branche (102l, 102r) s'écartant des composants (136), chaque bras de branche (102l, 102r) ayant une longueur, une largeur et une hauteur et
au moins une couche de graphite lié (402, 404) comprenant au moins une première couche de graphite (402l, 404l) et une seconde couche de graphite (402r, 404r) couplée chacune thermiquement aux composants électroniques (136) et montée respectivement sur une surface externe du premier bras de branche (102l) et du second bras de branche (102r) de la structure de montage optique (115).

2. Appareil d'affichage selon la revendication 1, dans lequel l'au moins une couche de graphite lié (402, 404) comprend du graphite pyrolytique.

3. Appareil d'affichage selon la revendication 1, dans lequel l'au moins une couche de graphite lié (402, 404) comprend un graphène stratifié.

4. Appareil d'affichage selon la revendication 1, dans lequel une feuille de graphite (402l, 402r, 404l, 404r) est liée par collage à la structure de montage optique (115).

5. Appareil d'affichage selon la revendication 4, dans lequel la première et la seconde couche de graphite (402l, 402r, 404l, 404r) sont liées par collage à la structure de montage optique (115) en utilisant l'un d'un adhésif époxy durcissable à température ambiante et d'un adhésif acrylique.

6. Appareil d'affichage selon la revendication 1, dans lequel chacune de la première et de la seconde couche de graphite (402l, 402r, 404l, 404r) a un plan de conductibilité thermique élevée le long d'un premier axe et de conductibilité thermique inférieure le long d'un second axe orthogonal au premier axe, chaque couche (402l, 402r, 404l, 404r) ayant une longueur et une largeur, où la longueur est plus longue que la largeur, la longueur ayant une première extrémité couplée aux composants électroniques (136) et une seconde extrémité se terminant sur ladite surface externe, et le premier axe s'aligne parallèlement à ladite longueur.

7. Appareil d'affichage selon la revendication 1, dans lequel chacune de la première et de la seconde couche de graphite (402l, 402r, 404l, 404r) est liée aux composants électroniques (136).

8. Appareil d'affichage selon la revendication 1, dans lequel la longueur de chaque bras de branche (102l, 102r) s'écarte des composants (136) vers l'extrémité du bras de branche respectif (102l, 102r), la largeur de chaque bras de branche (102l, 102r) est perpendiculaire à sa longueur respective et s'étend vers la tête d'un utilisateur de l'appareil d'affichage (2, 2a) monté sur la tête et la hauteur de chaque bras de branche (102l, 102r) est perpendiculaire à sa longueur et sa largeur respectives et
dans lequel la première couche de graphite (402l, 404l) et la seconde couche de graphite (402r, 404r) sont respectivement appliquées à un côté du premier bras de branche (102l) et du second bras de branche (102r), le côté d'un bras de branche (102l, 102r) correspondant à une surface externe du bras de branche (102l, 102r) s'étendant sur la longueur et la hauteur du bras de branche (102l, 102r).

9. Appareil d'affichage selon la revendication 1, dans lequel la longueur de chaque bras de branche (102l, 102r) s'écarte des composants (136) vers l'extrémité du bras de branche respectif (102l, 102r), la largeur de chaque bras de branche (102l, 102r) est perpendiculaire à sa longueur respective et s'étend vers la tête d'un utilisateur de l'appareil d'affichage (2, 2a) monté sur la tête et la hauteur de chaque bras de branche (102l, 102r) est perpendiculaire à sa longueur et sa largeur respectives et
dans lequel la première couche de graphite (402l, 404l) et la seconde couche de graphite (402r, 404r) sont respectivement appliquées à une partie supérieure du premier bras de branche (102l) et du second bras de branche (102r), la partie supérieure d'un bras de branche (102l, 102r) correspondant à la surface externe du bras de branche (102l, 102r) s'étendant sur la longueur et la largeur du bras de branche (102l, 102r) et étant orientée vers la partie supérieure de la tête de l'utilisateur.

10. Procédé de fourniture d'une structure de montage optique (115) pour un appareil d'affichage (2, 2a) monté sur la tête, comprenant :
la fourniture d'une structure de châssis (115) comprenant une surface interne et une surface externe, la structure de châssis (115) comprenant un premier et un second bras de branche (102l, 102r) ;
la fixation de composants électriques producteurs de chaleur (136) à la surface interne de la structure de châssis (115) ;
le couplage thermique d'au moins une couche de graphite (402, 404) aux composants électriques producteurs de chaleur (136), comprenant le couplage thermique d'au moins une première couche de graphite (402l, 404l) et d'une seconde couche de graphite (402r, 404r) de l'au moins une couche de graphite (402, 404) aux composants électriques producteurs de chaleur (136) ; et
la liaison respective de la première couche de graphite (402l, 404l) et de la seconde couche de graphite (402r, 404r) à la surface externe du premier bras de branche (102l) et du second bras de branche (102r) de la structure de châssis (115).

11. Procédé selon la revendication 10, dans lequel ladite liaison comprend l'application d'un adhésif entre la surface externe et une région de la couche de graphite (402l, 402r, 404l, 404r).

12. Procédé selon la revendication 10, comprenant en outre :
la formation de l'au moins une couche de graphite (402, 404) dans un trajet thermique préformé ayant une forme calibrée pour être montée sur l'extérieur de la structure de châssis (115).
